# EUROPÄISCHE PATENTSCHRIFT

(11) **EP 0 785 569 B1**
(45) Veröffentlichungstag und Bekanntmachung des Hinweises auf die Patenterteilung: **13.02.2008**
(21) Anmeldenummer: 96120621.6
(22) Anmeldetag: 20.12.1996
(51) Int. Cl.: H01J 37/32, H01J 37/317, C23C 16/50

(54) **Plasmareaktor**
Plasma reactor
Réacteur à plasma

(30) Priorität: 20.01.1996 DE 29600991 U
(43) Veröffentlichungstag der Anmeldung: 23.07.1997
(73) Patentinhaber: Strämke, Siegfried, Dr., D-52538 Selfkant (DE)
(72) Erfinder: Strämke, Siegfried, Dr., D-52538 Selfkant (DE)
(74) Vertreter: Selting, Günther

(56) Entgegenhaltungen:
- WO-A-95/19837
- DE-A1- 2 400 587
- DE-C1- 4 333 825
- US-A- 2 622 860
- US-A- 4 457 145

## Beschreibung

Die Erfindung betrifft einen Plasmareaktor für flexibles Strangmaterial.

Flexible Strangmaterialien, beispielsweise Drähte, unregelmäßige Faserbündel, wie z.B. Kammzüge aus Naturwolle, oder regelmäßige Fasergewirke und Fasergeflechte, z.B. technische Textilien werden in vielen Industriezweigen als Rohmaterialien und Zwischenprodukte verwendet. Um solche Strangmaterialien für den nachfolgenden Verarbeitungsschritt vorzubereiten, werden vielfach chemische Bearbeitungsverfahren eingesetzt, mit denen die Oberfläche des Strangmaterials modifiziert wird. Da chemische Bearbeitungsverfahren häufig mit starken Umweltbeeinträchtigungen verbunden sind, sind Versuche unternommen worden, die genannten Strangmaterialien einer Plasmabehandlung (PVD,CVD, Plasmaätzen) zu unterziehen, die eine gegenüber chemischen Bearbeitungsverfahren geringere Umweltbelastung zur Folge hat.

Um flexible Strangmaterialien einer kontinuierlichen Plasmabehandlung unterziehen zu können, sind als Versuchsanlagen Plasmareaktoren entwickelt worden, die einen Reaktorraum aufweisen, in welchen das Strangmaterial über einen Durchlaß für den Eintritt hineingeführt wird und aus welchem es über einen Durchlaß für den Austritt herausgeführt wird. Im Innern des Reaktorraums sind Elektroden angeordnet, die ein Plasma erzeugen, durch welches das Strangmaterial bewegt wird.

Um mit der Plasmabehandlung ein gutes Ergebnis erzielen zu können, ist es erforderlich, daß das zu bearbeitende Strangmaterial mehrere Minuten der Einwirkung des Plasmas ausgesetzt wird. Eine solch lange Bearbeitungszeit läßt sich erreichen, wenn das Strangmaterial im Innern des Plasmareaktors auf einem mäanderförmigen Weg geführt wird. Die Führung erfolgt bei bekannten Plasmareaktoren mittels Führungselementen, die das Strangmaterial entlang eines Bearbeitungsweges führen. Trotz einer solchen Führung sind die bekannten Plasmareaktoren sehr langgestreckte Apparate, in denen eine Vielzahl hintereinandergeschalteter Elektroden vorgesehen sind, die jeweils kleine, lokale Plasmen erzeugen. Die Vielzahl der Elektroden ist jedoch schwer zu steuern und es besteht die Gefahr örtlicher thermischer Zerstörung des zu bearbeitenden Strangmaterials. Darüber hinaus wirken sich die das Strangmaterial führenden Führungselemente negativ auf die Ausbildung des Plasmas und dessen Steuerbarkeit aus.

Bei den bekannten Plasmareaktoren besteht also neben dem Nachteil einer großen Baulänge und einer fehleranfälligen Strangführung auch der Nachteil ungenügender Steuerbarkeit und ungenügender Bearbeitungsqualität.

Der Erfindung liegt die Aufgabe zugrunde, einen kompakten Plasmareaktor für flexibles Strangmaterial zur Verfügung zu stellen, der eine gleichmäßige und schonende Bearbeitung des flexiblen Strangmaterials erlaubt.

Die Lösung dieser Aufgabe erfolgt erfindungsgemäß mit den Merkmalen des Patentanspruchs 1.

Gemäß der Erfindung ist vorgesehen, daß das mindestens eine Führungselement eine Walze ist, um die das Strangmaterial in mehreren axial gegeneinander versetzten Windungen umläuft. Die Plasmaquellen sind dabei derart angeordnet, daß das von ihnen erzeugte Plasma gleichzeitig Abschnitte mindestens zweier axial gegeneinander versetzter Windungen erfaßt. Durch den mehrfachen Umlauf des Strangmaterials um die gleiche Walze steht im Innern des Reaktorraums ein langer Bearbeitungsweg zur Verfügung, dessen Länge die Länge des Plasmareaktors um ein Vielfaches übertrifft. Der lange Bearbeitungsweg erlaubt lange Bearbeitungszeiten bei kompakter Bauweise des Plasmareaktors.

Durch die Mehrfachumlenkung des Strangmaterials an der gleichen Walze liegen gleichzeitig immer mindestens zwei Strangmaterialabschnitte so nebeneinander, daß sie durch das Plasma einer Plasmaquelle bearbeitbar sind. Die Plasmaquellen, vorzugsweise Elektroden, sind dazu passend ausgelegt und angeordnet und erzeugen ein räumlich ausgedehntes Plasma, das für die Bearbeitung mehrerer Strangmaterialabschnitte gleichzeitig genutzt wird. Das räumlich ausgedehnte Plasma ist wegen seiner Größe gegenüber einem Plasma, dessen Ausdehnung lediglich im Bereich der Größenordnung der Breite oder Dicke des Strangmaterials liegt, leichter zu steuern. Wegen der mehrfachen Umlenkung des Strangmaterials ist das Strangmaterial auch besonders gut zugänglich. Ein das Strangmaterial bearbeitendes Plasma wird dabei nicht durch Einbauten oder ähnliches in seiner Ausbildung gestört.

Wenn die Elektroden im Bereich freier Förderstrecken angeordnet sind, kann deren Plasma das Strangmaterial abschnittsweise einhüllen und besonders gleichmäßig bearbeiten. Bei einer solchen Ausgestaltung wird darüberhinaus die Ausbildung des Plasmas nicht einmal mehr durch die Walzen beeinträchtigt. Für die Einstellung des Plasmas ist als wesentliche Störgröße nur noch die Qualität des Strangmaterials zu berücksichtigen. Die gleichen Vorteile ergeben sich auch bei einem Plasma, das ohne Elektroden erzeugt wird, z.B. bei einem Mikrowellenplasma.

Wenn in dem Plasmareaktor lediglich eine Walze angeordnet ist, ist es vorteilhaft, das Strangmaterial von der Walze in freien Buchten herabhängen zu lassen. Es ist jedoch auch möglich, mit der Walze zusammenwirkende Wendeelemente vorzusehen, so daß das Strangmaterial zwischen der Walze und den Wendeelementen quasi aufgespannt geführt wird.

Besonders problematisch ist die Bearbeitung von faserigen Materialien, die eine geringe Zugfestigkeit aufweisen. Ein solches Material ist beispielsweise Kammzug aus Schafwolle, der vor dem Verspinnen bearbeitet werden muß, damit an den einzelnen Fasern des Kammzugs ausgebildete Schuppen entfernt werden. Das Entfernen der Schuppen dient der Vermeidung von Knotenbildung und Verfilzung. Wegen der geringen Zugfestigkeit dürfen faserige Materialien nur in geringem Maße auf Zug beansprucht werden. Über längere Strecken sind Zugkräfte quasi nicht übertragbar. Je kürzer die Faserlänge ist, desto geringer ist die Zugfestigkeit.

Ein Plasmareaktor, von dem der Oberbegriff des Patentanspruchs 1 ausgeht, ist beschrieben in WO 95/19837. Der Plasmareaktor enthält in einem Reaktorraum zwei mit Abstand angeordnete Walzen, um die das Strangmaterial abwechselnd herumgeführt ist. In dem Reaktorraum befinden sich Elektroden für die Erzeugung eines Plasmas, insbesondere in dem Bereich zwischen den beiden Walzen.

DE-A-2400587 beschreibt einen Plasmareaktor mit einer einzigen Walze, um die das Strangmaterial schraubenförmig herumgeführt ist. Auch hier befinden sich in dem Reaktorraum Elektroden zur Plasmaerzeugung.

US-A-2622860 beschreibt eine Bearbeitungsvorrichtung für Strangmaterial, das einen Ofen durchläuft. Das Strangmaterial wird dabei über eine Walze geführt, welche axial bewegbare Umsetzerelemente aufweist, welche das Strangmaterial auf der Walze in axialer Richtung vorschieben.

Die Erfindung befasst sich auch damit, die Plasmabearbeitung faseriger Materialien zu ermöglichen.

Der erfindungsgemäße Plasmareaktor ist durch die Merkmale des Patentanspruchs 1 definiert. Hiernach ist vorgesehen, dass an jeder der Walzen mindestens ein axial zu der Walze gesteuert bewegbares Umsetzerelement angeordnet ist, wobei die Umsetzerelemente das Strangmaterial in Abhängigkeit von der Drehstellung der Walzen in Achsrichtung der Walzen transportieren und hinsichtlich ihres Hubweges von einem gemeinsamen Einstellmechanismus einstellbar sind.

Mit den gemäß der Erfindung vorgesehenen Walzen wird dazu ein parallel zur Walzenachse erfolgender kontrollierter Materialtransport bewirkt. Dabei sind für die Bewegung quer zur Orientierung der Windungen nur kleine Kräfte aufzubringen. Mit dem erfindungsgemäßen Plasmareaktor können daher auch faserige Materialien, wie z.B. Kammzug aus Schafwolle bearbeitet werden.

Die für den Materialtransport in Längsrichtung des Strangmaterials erforderlichen Längskräfte werden bei einem Strangmaterial mit geringer Zugfestigkeit dadurch auf das Strangmaterial übertragen, dass mindestens zwei Walzen angeordnet sind, die rotierend angetrieben werden, so dass in Achsrichtung des Strangmaterials wirkende Kräfte über fast die gesamte Länge des Strangmaterials verteilt aufgebracht werden. Auch sind bei einer solchen Ausgestaltung für den Materialtransport in Längsrichtung des Strangmaterials keine längswirkenden Reibungskräfte zu überwinden. Die insgesamt erforderlichen Halte- und Transportkräfte sind dann gering, so dass auch die Längsspannungen im Innern des Strangmaterials gering sind.

Wenn im Innern des Reaktorraums des Plasmareaktors mindestens zwei achsparallele Walzen angeordnet sind, lassen sich im Bereich freier Förderstrecken zwischen den Walzen vorgegebene Transportbedingungen des Strangmaterials besonders gut einhalten. Darüberhinaus ist es bei der Anordnung zweier Walzen besonders einfach möglich, ein Plasma zu erzeugen, das das Strangmaterial gleichmäßig über dessen gesamten Umfang bearbeitet. Durch Elektroden oder Plasmaquellen, die im Innern der Umläufe des Strangmaterials liegen, kann ein die Ebene des Strangmaterials durchdringendes besonders wirksames Plasma erzeugt werden.

Der in Achsrichtung der Walzen erfolgende Materialtransport wird vorzugsweise dadurch bewirkt, daß je Walze mindestens ein Umsetzerelement vorgesehen ist. Die Umsetzerelemente, deren Umsetzbewegung vorzugsweise in Abhängigkeit von der Verdrehstellung der Walzen erfolgt, erlauben einen Quertransport des Strangsmaterials längs der Walzenachsen, ohne das an dem Strangmaterial quer zu dessen Längserstreckung Reibung verursachende Gleitbewegungen auftreten. Insbesondere faseriges Strangmaterial, dessen Reißfestigkeit gering ist, kann bei einer solchen Ausgestaltung bearbeitet werden.

Gemäß der Erfindung sind an jeder der Walzen mehrere langgestreckte, parallel zueinander und zur Achse der Walzen angeordnete Umsetzerelemente angeordnet, die gemeinsam im wesentlichen die Kontur eines Zylinders beschreiben und über ein Hubgetriebe zyklisch absenkbar sind. Durch die zyklische Absenkung der Umsetzerelemente kann das Strangmaterial in kleinen Schritten sehr gleichmäßig in Achsrichtung der Walzen transportiert werden, ohne daß das Material eine Gleitbewegung auf einer der Walzen erfährt. Dadurch wird ein reibungsbedingter Verschleiß der Walzen ebenso vermieden, wie die Gefahr des Reißens des Strangmaterials während des Materialtransports.

Vorzugsweise weist das Hubgetriebe eine feststehende Schrägscheibe auf, auf der die Umsetzerelemente aufstehend um die Drehachse der betreffenden Walze rotiert werden. Die Schrägscheibe stellt einen besonders einfachen und zuverlässigen Getriebetyp dar. Wenn die Neigung der Schrägscheibe gegenüber der Drehachse der betreffenden Walze einstellbar ist, läßt sich der in Achsrichtung erfolgende Materialtransport je Umlauf des Strangmaterials einstellen. Es ist auch ein Einzelantrieb der Führungen z.B. über Magnete u.ä. möglich.

Weitere vorteilhafte Ausgestaltungen und Weiterbildungen der Erfindung ergeben sich aus den Unteransprüchen sowie aus den Zeichnungen im Zusammenhang mit der Beschreibung, die besonders bevorzugte Ausführungsbeispiele betrifft.

Es zeigen:
- Fig. 1: einen erfindungsgemäßen Plasmareaktor gemäß einer ersten Ausführungsform in einem Längsschnitt,
- Fig. 2: den Plasmareaktor in Fig. 1 in einem Schnitt gemäß der Linie II-II in Fig. 1,
- Fig. 3: den Plasmareaktor in den Fign. 1 und 2 in einem Schnitt gemäß der Linie III-III in Fig. 1,
- Fig. 4: einen Plasmareaktor gemäß einer zweiten Ausführungsform in einem Längsschnitt,
- Fig. 5: den Plasmareaktor in Fig. 4 in einem Schnitt gemäß der Linie V-V in Fig. 4.

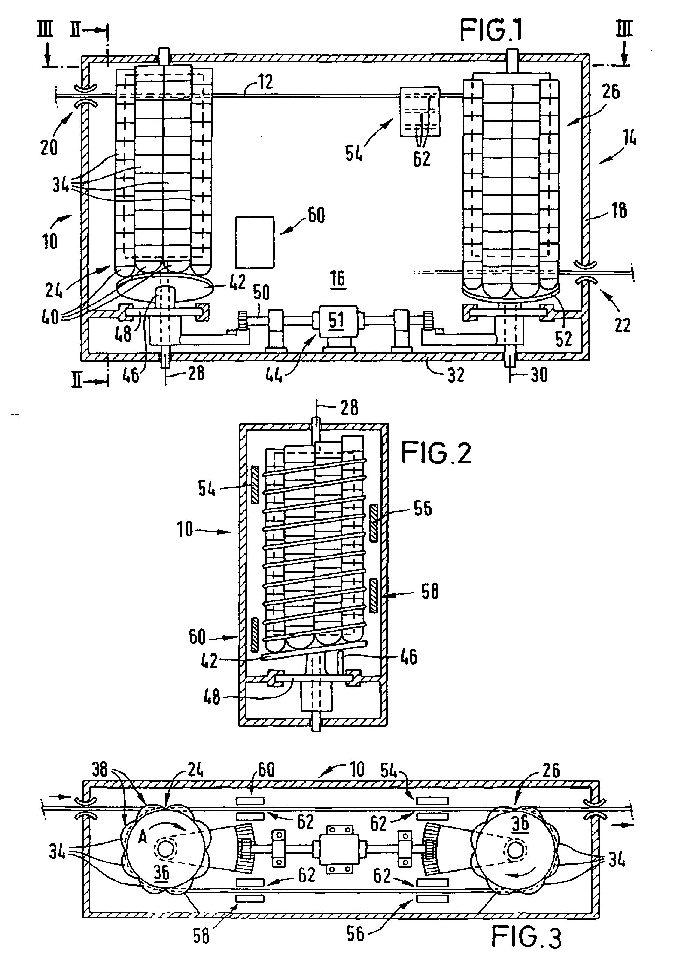

Der in Fig. 1 gezeigte Plasmareaktor 10 für flexibles Strangmaterial 12 weist einen im Innern eines Behälters 14 angeordneten Reaktorraum 16 für die Plasmabearbeitung auf. Eine kastenförmige starre Behälterwandung 18 des Behälters 14 hat an ihrer einen Stirnseite einen Durchlaß 20 für den Eintritt des Strangmaterials 12 in den Reaktorraum 16 und an ihrer anderen Stirnseite einen Durchlaß 22 für den Austritt des Strangmaterials 12 aus dem Reaktorraum 16.

Im Innern des Behälters 14 sind als Führungselemente für das Strangmaterial 12 eine erste Walze 24 und eine zweite Walze 26 angeordnet. Die Walzen 24,26 weisen zueinander parallele Drehachsen 28,30 auf, die voneinander beabstandet sind und sich senkrecht zu einer Bodenwand 32 des Behälters 14 erstrecken. Jede der Walzen 24,26 weist acht Umsetzerelemente 34 auf, die langgestreckte, stabförmige Leisten sind.

Die Umsetzerelemente 34 der ersten Walze 24 sind an einem ersten Grundkörper 36 in Richtung der Drehachse 28 verschiebbar geführt. An ihrer Außenseite weisen sie jeweils eine Mitnehmerfläche 38 für das Strangmaterial 12 auf, die entweder dem Verlauf der Zylindermantelfläche der Walze 24 exakt folgt oder eine nach außen gerichtete Wölbung starker Kümmung aufweist. Die Umsetzerelemente 34 stehen mit einer balligen Standfläche 40 auf einer Schrägscheibe 42 auf, die kippbar und um die Drehachse 28 verdrehfest in dem Reaktorraum 16 angeordnet ist. Die Umsetzerelemente 34 der ersten Walze 24 werden von dem Grundkörper 36 in Richtung des Pfeils A rotierend angetrieben, so daß sie während eines Umlaufs um die Drehachse 28 abgesenkt und wieder angehoben werden. Die Schrägscheibe 42 bildet also zusammen mit dem Grundkörper 36 und den Umsetzerelementen 34 ein Hubgetriebe.

Um den Weg, den die Umsetzerelemente 34 in Richtung der Drehachse 48 ausführen einstellen zu können, ist ein Verstellmechanismus 44 vorgesehen, der eine einen exzentrisch angeordneten Nocken 46 tragende Drehscheibe 48 aufweist. Die Drehscheibe 48 ist über ein Antriebsgestänge 50, das von einem Motor 51 angetrieben wird, derart drehbar, daß der Nocken 46 um die Drehachse 28 der ersten Walze 24 läuft und dabei die Schrägscheibe 42 einseitig anhebt oder absenkt.

Die zweite Walze 26 weist einen der ersten Walze 24 entsprechenden Aufbau auf. Sie unterscheidet sich von der ersten Walze 24 lediglich dadurch, daß die Neigung der Schrägscheibe 52 der zweiten Walze 26 der Neigung der Schrägscheibe 42 der ersten Walze 24 bezüglich der Drehachsen 28,30 entgegengesetzt ist.

Das Strangmaterial 12, das in dem Reaktorraum 16 bearbeitet wird, läuft von dem Durchlaß 20 an der ersten Walze 24 vorbei zu der zweiten Walze 26. An der zweiten Walze 26 liegt das Strangmaterial zunächst an einem Umsetzerelement 34 an, das sich in seiner am weitesten angehobenen Position befindet. Das Strangmaterial umschlingt die zweite Walze 26 mit einem Umschlingungswinkel von 180°, wobei es je nach Verdrehstellung der Walze 26 an drei oder an vier weiteren Umsetzerelementen 34 anliegt. Von der zweiten Walze 26 läuft das Strangmaterial zurück zu der ersten Walze 24, an der es an einem Umsetzerelement anliegt, das sich an seiner höchsten Position befindet. Im Verlauf einer 180° Umschlingung an der ersten Walze 24 liegt das Strangmaterial 12 wiederum je nach Verdrehstellung der Walze 24 an drei oder vier Umsetzerelementen 34 an, die sich jeweils auf einem niedrigeren Niveau befinden als das vorhergehende Umsetzerelement an dieser Walze 24. Von der ersten Walze 24 läuft das flexible Strangmaterial 12 dann wieder zu der zweiten Walze 26, wobei das Strangmaterial auf seinem Weg vom Durchlaß 20 für den Eintritt zu dem Durchlaß 22 für den Austritt mehrmals zwischen den Walzen in gegeneinander versetzten Windungen hin- und herläuft.

Da das Strangmaterial die beiden Walzen 24,26 jeweils nur auf der Seite umschließt, an der die Umsetzerelemente 34 auf ihrem Weg um die jeweilige Drehachse 28,30 eine abwärtsgerichtete Bewegung ausführen, wird das Strangmaterial 12 von dem obenliegenden Durchlaß 20 an der Eintrittsseite zu dem untenliegenden Durchlaß 22 an der Austrittsseite geführt. Ihre Aufwärtsbewegung führen die Umsetzerelemente 34 im wesentlichen in einem Bereich durch, in dem kein Strangmaterial 12 an ihnen anliegt. Die Umsetzelemente 34 können auch in einer horizontalen Lage betrieben werden, wenn sie zwangsgeführt sind. Dabei können die Walzen auch übereinander angeordnet sein.

Um in dem Reaktorraum 16 eine Plasmabearbeitung durchführen zu können, ist der Behälter 14 an eine nicht gezeigte Saugquelle angeschlossen, die in dem Reaktorraum 16 ein Vakuum erzeugt. Außerdem ist eine nicht gezeigte Gaseinlaßvorrichtung vorgesehen, mit der Inert- und/oder Reaktionsgase in den Reaktorraum geleitet werden können. Die Anordnung der Gaseinlaßvorrichtung und der Saugquelle erfolgt derart, daß der Plasmareaktor als Gegenstromreaktor, als Querstromreaktor und/oder als Kreuzstromreaktor betreibbar ist.

Um in dem Reaktorraum 16 ein oder mehrere großflächige Plasmen zu erzeugen, sind mehrere Elektrodenpaare 54,56,58,60 vorgesehen, wobei die Elektroden der Elektrodenpaare 54,56,58,60 jeweils derart voneinander beabstandet angeordnet sind, daß zwischen ihnen das Strangmaterial 12 hindurchführbar ist. Die Elektroden erzeugen jeweils ein Plasma, das Strangmaterialabschnitte 62 mehrerer in Achsrichtung gegeneinander versetzter Windungen des Strangmaterials 12 umschließt.

Die Elektrodenpaare 54,56,58,60 sind in Achsrichtung der Walzen 24,26, in unterschiedlichen Höhen angeordnet. Sie befinden sich zwischen den Walzen 24,26 im Bereich freier Förderstrecken des Strangmaterials 12, in Bereichen also in denen das Strangmaterial 12 nicht abgesetützt ist. Dabei sind sie sowohl an den Verbindungsbereich der Walzen 24,26 angeordnet, in dem das Strangmaterial von der ersten Walze 24 zu der zweiten Walze 26 läuft als auch in dem Verbindungsbereich, in dem das Strangmaterial von der zweiten Walze 26 zu der ersten Walze 24 verläuft. Der Abstand in Achsrichtung der Walzen 24,26 zwischen den in absteigender Reihenfolge angeordneten Elektrodenpaaren 54,56,58,60 ist jeweils gleich groß. Die das Strangmaterial 12 bearbeitenden Plasmen können außer durch Elektroden auch durch andere Plasmaquellen, z.B. Mikrowellenquellen, erzeugt werden.

Um mit dem Plasmareaktor 10 zum Beispiel Kammzug aus Schafwolle zu bearbeiten, wird der Reaktor zunächst in einem Vorbereitungsschritt beschickt, wobei das Strangmaterial so lange in gegeneinander versetzten Windungen um die Walzen 24,26 geführt wird, bis der Höhenunterschied zwischen dem Durchlaß 20 und dem Durchlaß 22 überwunden ist. Nach dem Evakuieren des Reaktorraums 16 und dem Einstellen einer gewünschten Gasatmosphäre wird mittels einer geeigneten Stromquelle zwischen den Elektrodenpaaren 54,56,58,60 jeweils ein Plasma gezündet. Das Strangmaterial 12 wird durch den Durchlaß 20 hindurch kontinuierlich in den Reaktorraum 16 hineingeführt und durch den Durchlaß 20 hindurch kontinuierlich herausgezogen. Die erste und die zweite Walze 24,26 werden mit einer Umfangsgeschwindigkeit angetrieben, die der Zuführ- und Abzugsgeschwindigkeit des Strangmaterials 12 entspricht.

Je nach Art der Plasmabearbeitung sind längere oder kürzere Verweilzeiten des Strangmaterials 12 in dem Plasmareaktor 10 erforderlich. Die Bearbeitungszeit läßt sich bei vorgegebener Umfangsgeschwindigkeit der Walzen 24,26 durch die Anzahl der Windungen des Strangmaterials 12 in dem Plasmareaktor 10 einstellen. Wenn bei einer kurzen Bearbeitungszeit eine geringe Anzahl von Windungen erforderlich ist, wird die Steigung der Schrägscheiben 42,52 mit dem Motor 51 vergrößert. Wenn eine lange Bearbeitungszeit gewünscht wird, wird das Strangmaterial 12 in einer großen Anzahl von Windungen um die Walzen 24,26 gelegt. In diesem Fall wird die Neigung der Schrägscheiben 42,52 verringert, so daß diese nahezu senkrecht zu den Drehachsen 28,30 verlaufen.

Bei der Verarbeitung von Naturwolle dient der Plasmareaktor 10 vor allem zu Entfettung und zum Entfernen von Schuppen. Es ist aber auch möglich, den Plasmareaktor 10 zur Oberflächenbearbeitung von Draht oder Kunststoffen und Kunstfaserstoffen zu verwenden, z.B. zur Plasmapolimerisation, zur Aktivierung von Kevlarfasern, zum Metallisieren oder zum Plasmaätzen.

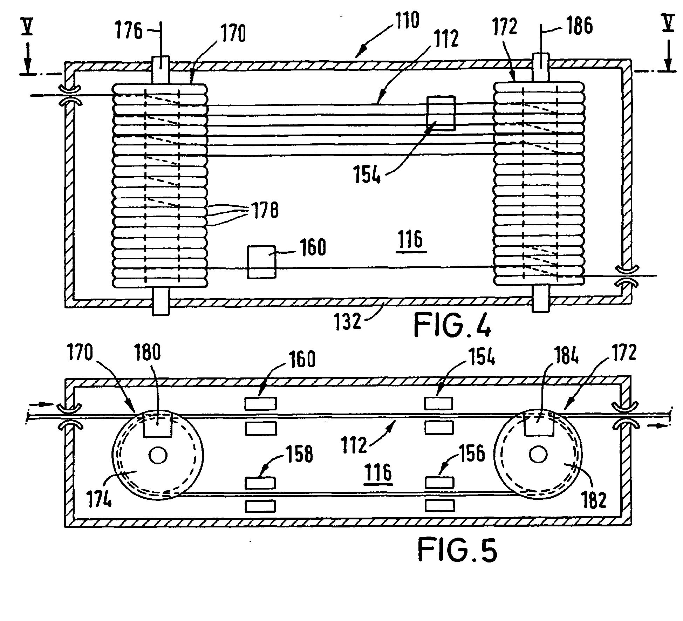

Der Plasmareaktor 110 gemäß der zweiten Ausführungsform in den Fign. 4 und 5 unterscheidet sich von dem Plasmareaktor 10 gemäß der ersten Ausführungsform lediglich durch die Ausgestaltung der ersten Walze 170 und der zweiten Walze 172. Teile des Plasmareaktors 110 gemäß der zweiten Ausführungsform, die Teilen des Plasmareaktors 10 gemäß der ersten Ausführungsform entsprechen, sind daher mit Bezugszeichen versehen, die gegenüber der ersten Ausführungsform um 100 erhöht sind.

Die erste Walze 170 weist einen Walzenkörper 174 auf, an dessen äußerer im wesentlichen, zylindrischer Oberfläche eine Vielzahl zueinander parallellaufender und zu der Achse 176 des Walzenkörpers konzentrischer Rillen 178 ausgebildet sind. In den Rillen 178 wird das Strangmaterial 112 geführt. Um das Strangmaterial 112 von einer Rille 178 in eine darunterliegende Rille 178 zu überführen, ist in den Walzenkörper 174 eine Umsetzerleiste 180 eingelassen, die mit dem Walzenkörper 174 mitrotiert und das Strangmaterial 112 in Achsrichtung versetzt. Die zweite Walze 172 ist entsprechend der ersten Walze 170 aufgebaut und weist eine in einem Walzenkörper 182 eingelassene Umsetzerleiste 184 auf. Die beiden Walzenkörper 174,182 werden mit einer übereinstimmenden Geschwindigkeit gedreht, wobei die Umsetzerleisten 180,184 bezüglich einer die Achsen 176 der ersten Walze 170 mit der Achse 186 der zweiten Walze 172 verbindenden Ebene stets die gleiche Verdrehstellung aufweisen. Die beiden Umsetzerleisten 180,184 werden in Abhängigkeit der Verdrehstellung der Walzenkörper 174,182 zeitgleich axial bewegt, so daß ein koordinierter Materialvorschub des Strangmaterials in Richtung der Achsen 176,186 erfolgt.

## Patentansprüche

1. Plasmareaktor für flexibles Strangmaterial (12) mit Durchlässen (20,22) für Eintritt und Austritt des Strangmaterials (12) in den Reaktorraum (16), in dem Reaktorraum (16) zur Erzeugung eines Plasmas angeordneten Plasmaquellen und mit einer in dem Reaktorraum (16) angeordneten Führungsvorrichtung, mit dem das Strangmaterial (12) entlang eines Bearbeitungsweges führbar ist,
wobei die Führungsvorrichtung mindestens zwei achsparallele, synchron rotierende Walzen (24,26;170,172) aufweist, um die das Strangmaterial (12) in mehreren axial gegeneinander versetzten Windungen umläuft, und die Plasmaquellen derart angeordnet sind, dass das von ihnen erzeugte Plasma gleichzeitig Abschnitte (62) mindestens zweier axial gegeneinander versetzter Windungen erfasst,
**dadurch gekennzeichnet,**
**dass** an jeder der Walzen mindestens ein axial zu der Walze gesteuert bewegbares Umsetzerelement (34;180,184) angeordnet ist, wobei die Umsetzerelemente (34;180,184) das Strangmaterial (12;112) in Abhängigkeit von der Drehstellung der Walzen (24,26;170,172) in Achsrichtung der Walzen (24,26;170,172) transportieren und hinsichtlich ihres Hubweges von einem gemeinsamen Einstellmechanismus (44) einstellbar sind.

2. Plasmareaktor nach Anspruch 1, **dadurch gekennzeichnet, dass** jede der Walzen (24,26) mehrere langgestreckte, parallel zueinander und zu den Achsen (28,30) der Walzen (24,26) angeordnete Umsetzerelemente (34) aufweist, wobei die Umsetzerelemente (34) jeder Walze (24,26) über ein Hubgetriebe zyklisch absenkbar sind.

3. Plasmareaktor nach Anspruch 2, **dadurch gekennzeichnet, dass** das Hubgetriebe eine feststehende Schrägscheibe (42,52) aufweist, und dass die Umsetzerelemente (34) auf der Schrägscheibe (42,52) laufend um die Drehachse (28,30) der betreffenden Walze (24,26) rotiert werden.

4. Plasmareaktor nach Anspruch 3, **dadurch gekennzeichnet, dass** die Neigung der Schrägscheibe (42,52) gegenüber der Drehachse (28,30) der betreffenden Walze (24,26) einstellbar ist.

5. Plasmareaktor nach einem der Ansprüche 1-4, **dadurch gekennzeichnet, dass** die Plasmaquellen Elektroden (54,56,58,60) sind.

6. Plasmareaktor nach Anspruch 5, **dadurch gekennzeichnet, dass** die Elektroden (54,56,58,60) zwischen den Walzen (24,26) im Bereich freier Förderstrecken des Strangmaterials (12) angeordnet sind und jeweils paarweise zwischen sich ein Plasma erzeugen, durch welches das Strangmaterial (12) hindurchgeführt wird.

7. Plasmareaktor nach einem der Ansprüche 1-4, **dadurch gekennzeichnet, dass** die Plasmaquellen Hochfrequenzstrahler sind.

8. Plasmareaktor nach Anspruch 1, **dadurch gekennzeichnet, dass** die die Walzen (170,172) jeweils mehrere parallel zueinander ausgerichtete Führungsrillen (178) aufweisen, die in zu den jeweiligen Rotationsachsen (176,186) der Walzen (170,172) senkrechten Ebenen liegen und dass die Umsetzerelemente (180,184) das Strangmaterial (112) von der Ebene einer Führungsrille (178) in die Ebene einer darunter liegenden Führungsrille (178) versetzen.

## Claims

1. A plasma reactor for flexible strand material (12), comprising passages (20,22) for the strand material (12) to enter into and exit from the reactor chamber (16), plasma sources arranged in the reactor chamber (16) for generating a plasma, and a guiding device arranged in the reactor chamber (16) and adapted to guide the strand material (12) along a processing path,
wherein the guiding device comprises at least two synchronously rotating rollers (24,26;170,172) orientated with parallel axes, about which the strand material (12) revolves in several windings which are axially offset with respect to each other, and wherein the plasma sources are arranged such that the plasma generated by them simultaneously acts on portions (62) of at least two windings axially offset with respect to each other,
**characterized in that**
each of the rollers is provided with at least one displacement element (34;180,184) movable under control in an axial direction with respect to the roller, the displacement elements (34;180,184) transporting the strand material (12;112) in dependence on the rotational position of the rollers (24,26;170,172) in the axial direction of the rollers (24,26;170,172), their stroke being adjustable by means of a common adjustment mechanism (44).

2. The plasma reactor according to claim 1, wherein each of the rollers (24,26) comprises several elongated displacement elements (34) parallel to each other and to the axes (28,30) of the rollers (24,26), the displacement elements (34) of each roller (24,26) being cyclically lowerable via a lowering gear.

3. The plasma reactor according to claim 2, wherein the lowering gear comprises a stationary swash plate (42,52), and wherein the displacement elements (34) are rotated about the rotational axis (28, 30) of the respective roller (24,26) while moving on the swash plate (49,52).

4. The plasma reactor according to claim 3, wherein the inclination of the swash plate (42,52) with respect to the rotational axis (28,30) of the respective roller (24,26) can be adjusted.

5. The plasma reactor according to one of claims 1-4, wherein the plasma sources are electrodes (54,56,58,60).

6. The plasma reactor according to claim 5, wherein the electrodes (54,56,58,60) are arranged between the rollers (24,26) in the region of free transport paths of the strand material (12) and generate, in pairs, a respective plasma between them through which plasma the strand material (12) is passed.

7. The plasma reactor according to one of claims 1-4, wherein the plasma sources are high-frequency radiators.

8. The plasma reactor according to claim 1, wherein each of the rollers (170,172) comprise guiding grooves (178) arranged in parallel to each other and situated in planes vertical to the respective rotational axes (176,186) of the rollers (170,172), and wherein the displacement elements (180,184) transfer the strand material (112) from the plane of one guiding groove (178) into the plane of a guiding groove (178) situated therebelow.

## Revendications

1. Réacteur à plasma pour du matériau en boudin (12) flexible, comprenant des orifices (20, 22) pour l'entrée et la sortie du matériau en boudin (12) dans la chambre (16) du réacteur, des sources de plasma disposées dans la chambre (16) du réacteur, pour la génération d'un plasma, ainsi qu'un dispositif de guidage disposé dans la chambre (16) du réacteur, à l'aide duquel le matériau en boudin (12) peut être dirigé le long d'un trajet de traitement,
le dispositif de guidage présentant au moins deux rouleaux (24, 26 ; 170, 172) d'axes parallèles, entraînés en rotation de façon synchrone, autour desquels le matériau en boudin (12) circule en plusieurs spires décalées axialement l'une par rapport à l'autre, et les sources de plasma étant positionnées de telle manière que le plasma, qu'elles génèrent, touche simultanément des tronçons (62) d'au moins deux spires décalées axialement l'une par rapport à l'autre,
**caractérisé**
**en ce que** sur chacun des rouleaux est disposé au moins un organe de changement de place (34 ; 180, 184) déplaçable, de façon commandée, dans la direction axiale du rouleau, les organes de changement de place (34 ; 180, 184) transportant alors le matériau en boudin (12 ; 112) dans la direction de l'axe des rouleaux (24, 26 ; 170, 172), en fonction de la position angulaire des rouleaux (24, 26 ; 170, 172), et étant réglables, en ce qui concerne leur course, par un mécanisme de réglage (44) commun.

2. Réacteur à plasma selon la revendication 1, **caractérisé en ce que** chacun des rouleaux (24, 26) présente plusieurs organes de changement de place (34) allongés, disposés parallèlement l'un à l'autre et aux axes (28, 30) des rouleaux (24, 26), les organes de changement de place (34) de chaque rouleau (24, 26) pouvant être abaissés cycliquement par l'intermédiaire d'un système élévateur.

3. Réacteur à plasma selon la revendication 2, **caractérisé en ce que** le système élévateur présente un disque oblique (42, 52) fixe, et **en ce que** les organes de changement de place (34) sont entraînés en rotation autour de l'axe de rotation (28, 30) du rouleau (24, 26) considéré, en circulant sur le disque oblique (42, 52).

4. Réacteur à plasma selon la revendication 3, **caractérisé en ce que** l'inclinaison du disque oblique (42, 52), par rapport à l'axe de rotation (28, 30) du rouleau (24, 26) considéré, est réglable.

5. Réacteur à plasma selon l'une des revendications 1 à 4, **caractérisé en ce que** les sources de plasma sont des électrodes (54, 56, 58, 60).

6. Réacteur à plasma selon la revendication 5, **caractérisé en ce que** les électrodes (54, 56, 58, 60) sont disposées entre les rouleaux (24, 26), dans la région de longueurs libres de transport du matériau en boudin (12), et, par paires respectives, génèrent entre elles un plasma, à travers lequel le matériau en boudin (12) est dirigé.

7. Réacteur à plasma selon l'une des revendications 1 à 4, **caractérisé en ce que** les sources de plasma sont des émetteurs de rayonnement haute fréquence.

8. Réacteur à plasma selon la revendication 1, **caractérisé en ce que** les rouleaux (170, 172) présentent chacun plusieurs gorges de guidage (178) orientées parallèlement l'une à l'autre, qui sont situées dans des plans perpendiculaires aux axes de rotation (176, 186) respectifs des rouleaux (170, 172), et **en ce que** les organes de changement de place (180, 184) font passer le matériau en boudin (112) du plan d'une gorge de guidage (178) dans le plan d'une gorge de guidage (178) située en dessous.
